# EUROPEAN PATENT APPLICATION

(11) **EP 4 761 480 A1**
(43) Date of publication of application: **17.06.2026**
(21) Application number: 25222545.3
(22) Date of filing: 11.12.2025
(51) Int. Cl.: H05K 7/14

(54) **ADJUSTABLE SUBSTRATE RETAINER**

(30) Priority: 16.12.2024 US 202463734264 P
(71) Applicant: Murata Manufacturing Co., Ltd., Nagaokakyo-shi, Kyoto 617-8555 (JP)
(72) Inventor: KHAN, Zibran Aziz, Kyoto, 617-8555 (JP); CASTILLO, Adolfo, Kyoto, 617-8555 (JP)
(74) Representative: Lorenz Seidler Gossel Part. mbB

(57) **Abstract**

A substrate assembly includes a first substrate, a second substrate, a retainer attached to the second substrate, and a housing connected to the first substrate. The retainer is mounted to the housing, and the first substrate and the second substrate are electrically connected. The retainer includes an adjustable arm that is configured to vary in length, and a clamp that engages the second substrate.

## Description

### CROSS REFERENCE TO RELATED APPLICATIONS

This application claims the benefit of U.S. Patent Application No. 63/734,264 filed on December 16, 2024. The entire contents of this application are hereby incorporated by reference.

### BACKGROUND OF THE INVENTION

### 1. Field of the Invention

The present invention relates to a substrate retainer. More specifically, the present invention relates to a substrate retainer with an adjustable length arm that is able to receive substrates of varying thicknesses.

### 2. Description of the Related Art

Known substrate assemblies include structures that secure secondary substrates to a main substrate, including, for example, vertical card guides, card edge connectors, and standoffs. The secondary substrates can be mounted vertically (perpendicular to the main substrate) or horizontally (parallel to the main substrate).

Vertical card guides are generally used for vertically mounted secondary substrates. Card edge connectors are also generally used for vertically mounted secondary substrates. Standoffs are generally used for horizontally mounted secondary substrates.

A common disadvantage of the known solutions described above is an inability to adapt to different substrate thicknesses. That is, a change in substrate thickness requires a replacement of some or all of the components used to secure the secondary substrate. Furthermore, the known solutions described above also occupy space on the main substrate, reducing space for electrical components and the like. In particular, vertical card guides take up significant space in the substrate assembly. Furthermore, card edge connectors are costly to manufacture, particularly if the card edge connectors are designed to be resistant to vibrations.

### SUMMARY OF THE INVENTION

To overcome the problems described above, example embodiments of the present invention provide substrate assemblies including retainers that are able to secure substrates, such as secondary substrates that are vertically or horizontally mounted on a main substrate or motherboard in an electronics assembly. The example embodiments of the present invention are able to protect substrates from the effects of shock and vibration, while being adjustable to provide a one-size-fits-all solution.

A substrate assembly includes a first substrate, a second substrate, a retainer attached to the second substrate, and a housing connected to the first substrate. The retainer is mounted to the housing, and the first substrate and the second substrate are electrically connected. The retainer includes an adjustable arm that is configured to vary in length, and a clamp that engages the second substrate.

A major planar surface of the second substrate can be perpendicular or substantially perpendicular to a major planar surface of the first substrate. The first substrate and the second substrate can be oriented perpendicular or substantially perpendicular with respect to one another. The first substrate and the second substrate can be directly physically connected.

A major planar surface of the second substrate can be parallel or substantially parallel to a major planar surface of the first substrate. The first substrate and the second substrate can be oriented parallel or substantially parallel with respect to one another.

The substrate assembly can further include an intermediate connector connecting the first substrate and the second substrate.

The clamp can define a slot that engages with an edge portion of the second substrate. The slot of the clamp can include a leaf spring. The clamp can include an embedded spring. The adjustable arm can be configured to vary in length in a direction that is parallel or substantially parallel to a major planar surface of the first substrate.

The adjustable arm can include a set screw. When the set screw is loosened, the adjustable arm can be configured to vary in length. When the set screw is tightened, the adjustable arm can be configured to be fixed in length.

The adjustable arm can include a button release. When the button release is pressed down, the adjustable arm can be configured to vary in length. When the button release is not pressed down, adjustable can be configured to be fixed in length.

The substrate assembly can further include a fastener, the retainer can include a through hole, and the housing can include a threaded mounting point. The retainer can be attached to the housing by the fastener passing through the through hole and mating with the threaded mounting point.

The adjustable arm can include a snap fit mounting portion, and the housing can include a snap fit mounting point. The retainer can be attached to the housing by the snap fit mounting portion engaging with the snap fit mounting point.

The housing can include a first housing portion and a second housing portion. The first housing portion can be connected to the first substrate, and the retainer can be mounted to the second housing portion. The first housing portion can define a wall that is perpendicular or substantially perpendicular to a wall defined by the second housing portion.

The substrate assembly can further include an additional retainer attached to the second substrate. The retainer and the additional retainer can be attached to opposing edge portions of the second substrate.

The substrate assembly can further include a third substrate and an additional retainer attached to the third substrate. The first substrate and the third substrate can be electrically connected. The second substrate and the third substrate can be electrically connected. A thickness of the second substrate can be different from a thickness of the third substrate.

A major planar surface of the second substrate can be parallel or substantially parallel to a major planar surface of the third substrate. A major planar surface of the third substrate can be perpendicular or substantially perpendicular to a major planar surface of the first substrate. A major planar surface of the third substrate can be parallel or substantially parallel to a major planar surface of the first substrate.

The first substrate and the third substrate can be directly physically connected. The second substrate and the third substrate can be connected by an intermediate connector.

The above and other features, elements, characteristics, steps, and advantages of the present invention will become more apparent from the following detailed description of example embodiments of the present invention with reference to the attached drawings.

### BRIEF DESCRIPTION OF THE DRAWINGS

Fig. 1 is a perspective view of a substrate assembly including a vertically mounted secondary substrate.
Fig. 2 is a side view of the substrate assembly shown in Fig. 1.
Fig. 3 is a top view of the substrate assembly shown in Fig. 1.
Fig. 4 is a front view of the substrate assembly shown in Fig. 1.
Figs. 5-8 show the substrate assembly of Fig. 1 populated with multiple vertically mounted secondary substrates.
Fig. 9 is a perspective view of a substrate assembly including horizontally mounted secondary substrates.
Fig. 10 is a side view of the substrate assembly shown in Fig. 9.
Fig. 11 is a top view of the substrate assembly shown in Fig. 9.
Fig. 12 is a front view of the substrate assembly shown in Fig. 9.
Fig. 13 is a perspective view of a retainer including a leaf spring.
Fig. 14 is a side view of the retainer shown in Fig. 13.
Fig. 15 is a top view of the retainer shown in Fig. 13.
Fig. 16 cross-sectional side view of the retainer shown in Fig. 13.
Fig. 17 is a first perspective view of a retainer configured to mate with a set screw.
Fig. 18 shows the retainer of Fig. 17 mated with a set screw.
Fig. 19 is a second perspective view of the retainer shown in Fig. 17.
Fig. 20 is a first perspective view of a retainer including a button release.
Fig. 21 is a second perspective view of the retainer shown in Fig. 20.
Fig. 22 is a perspective view of a retainer including a snap-fit portion.
Fig. 23 is a top view of the retainer shown in Fig. 22.
Fig. 24 is a perspective view of a retainer including an internal or embedded spring.
Fig. 25 is a side view of the retainer shown in Fig. 24.
Fig. 26 is a cross-sectional side view of the retainer shown in Fig. 24.

### DETAILED DESCRIPTION OF EXAMPLE EMBODIMENTS

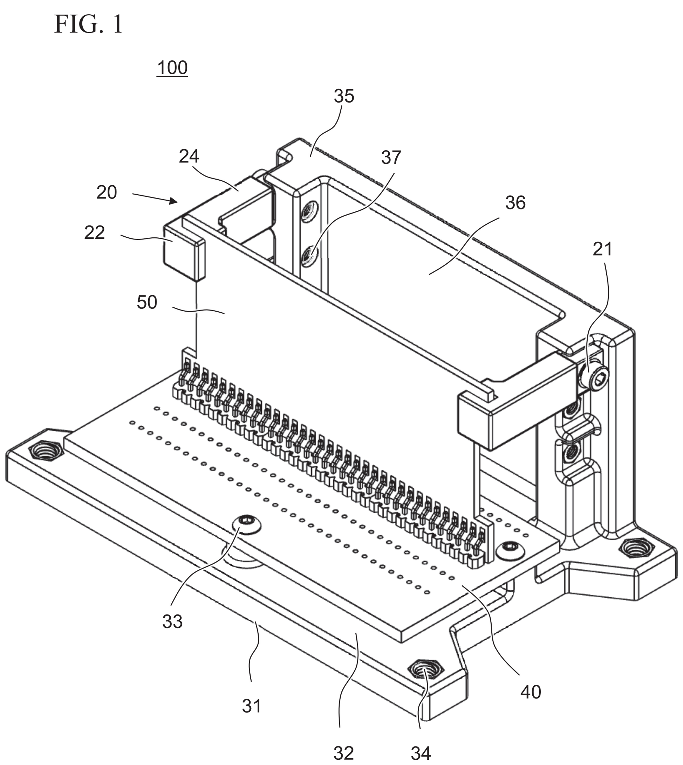

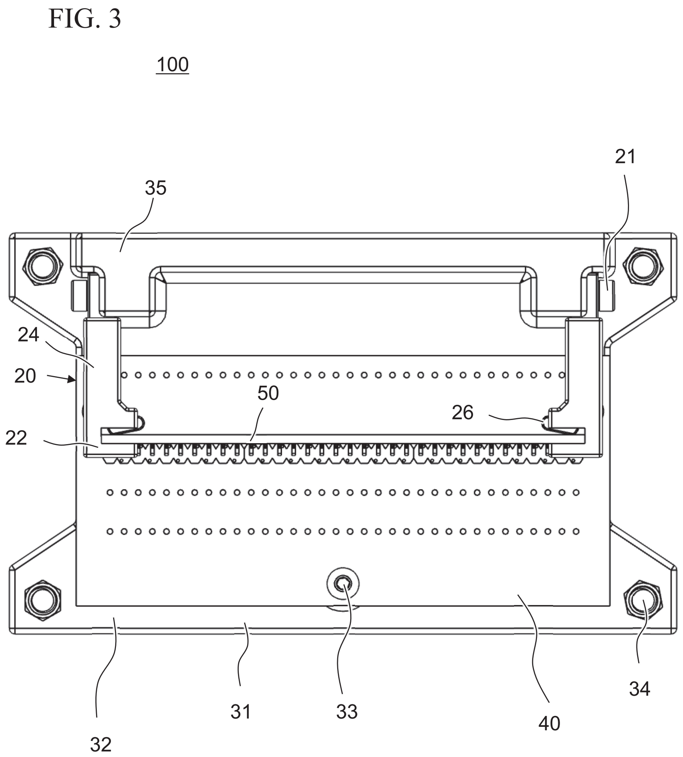

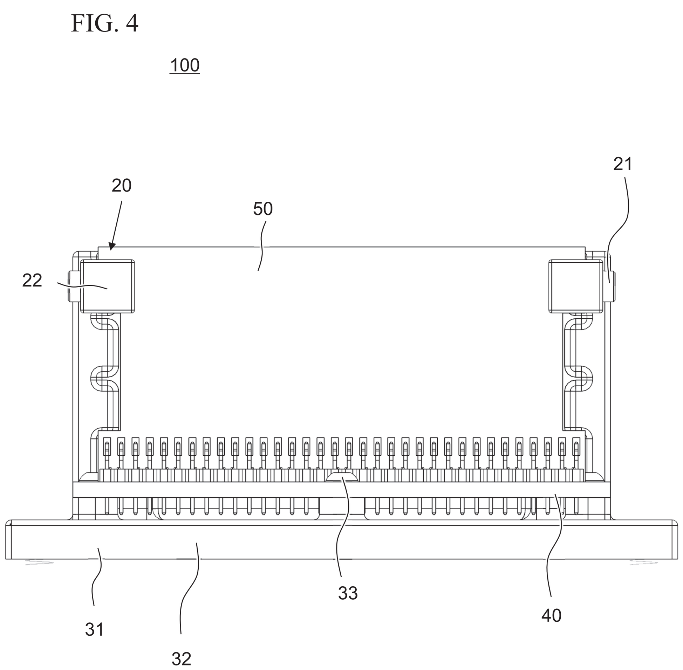

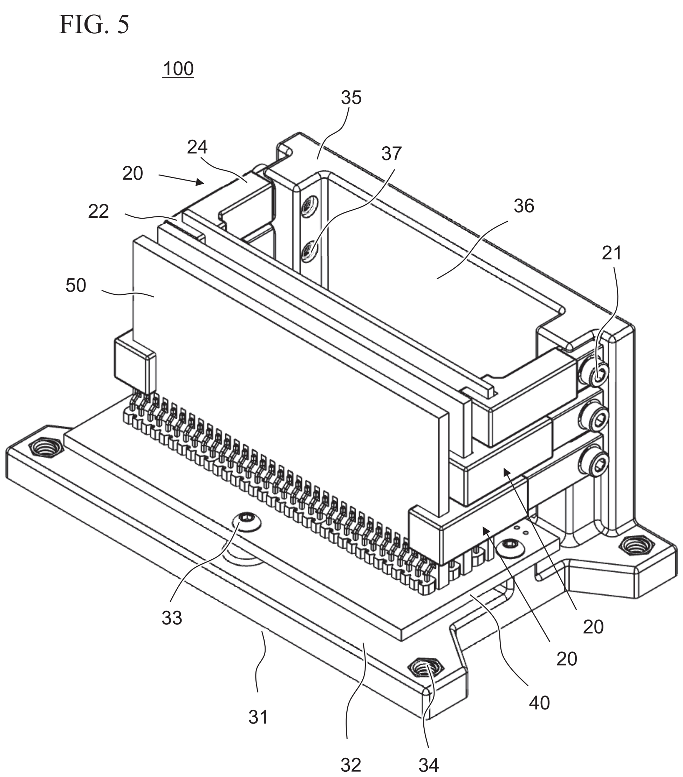

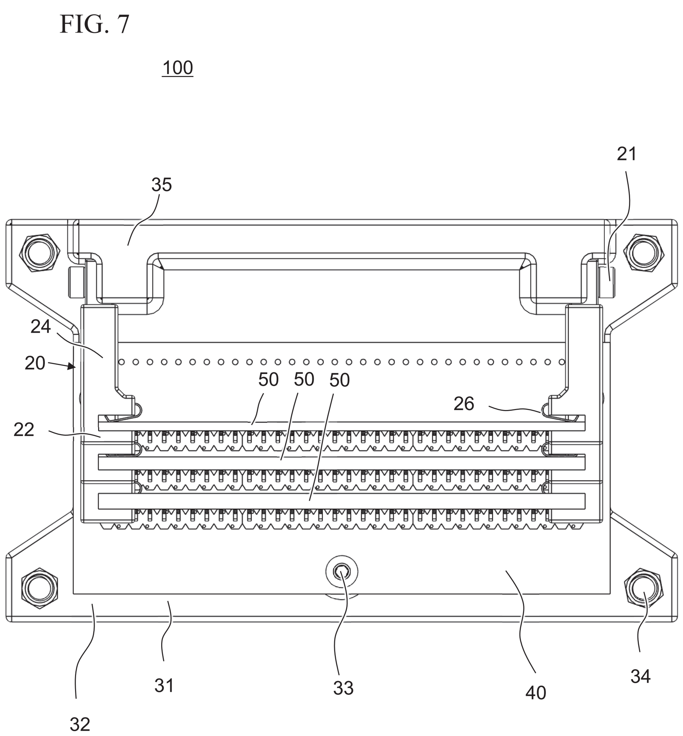

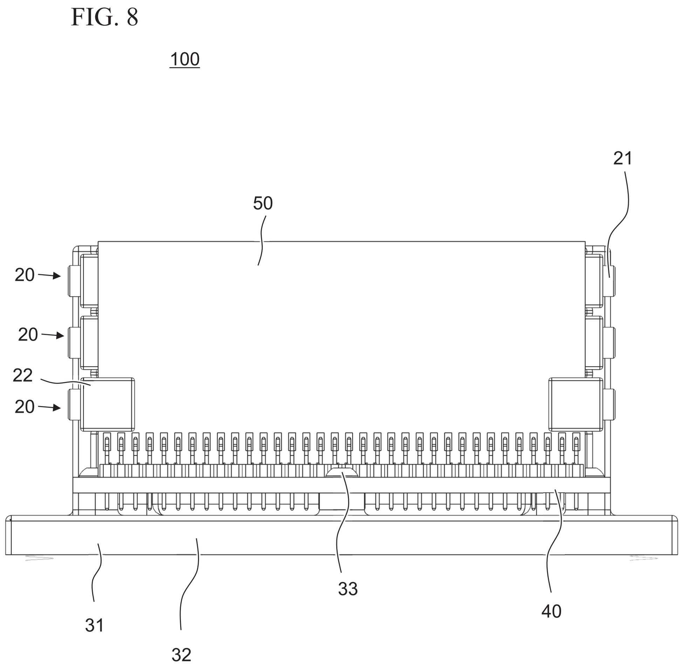

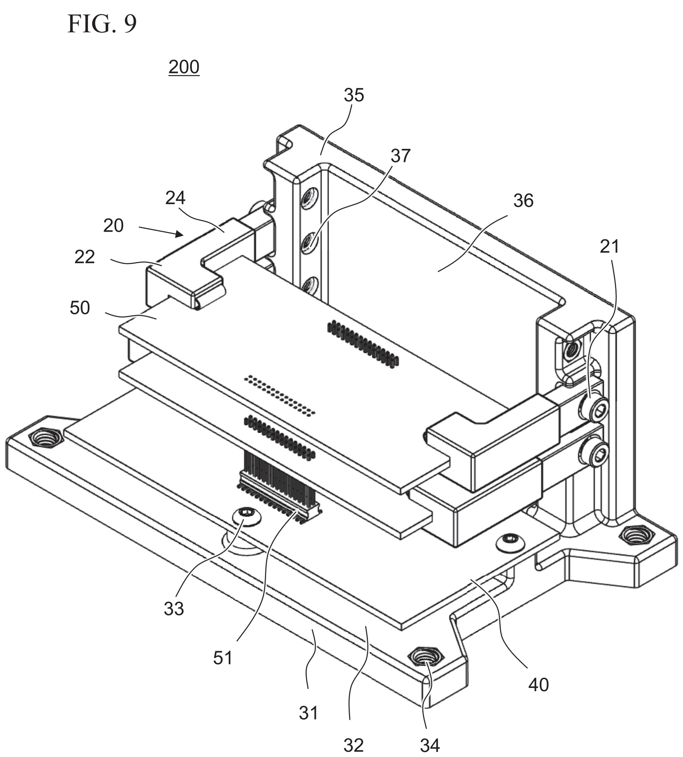

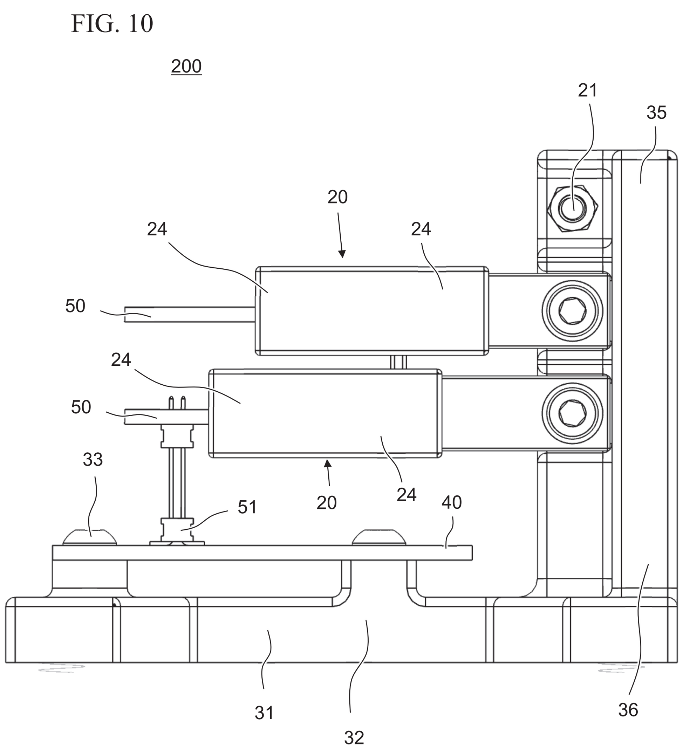

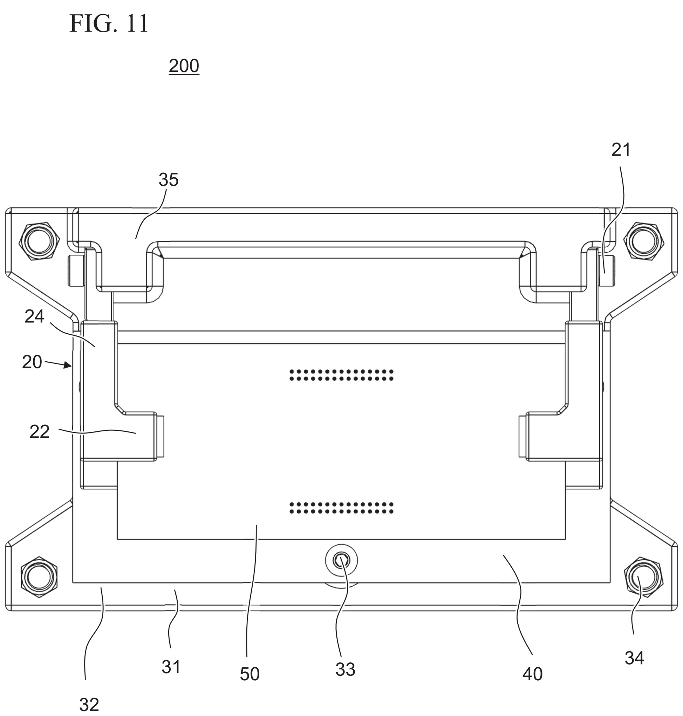

Figs. 1-4 show a substrate assembly 100 including a vertically mounted secondary substrate 50. Figs. 5-8 show the substrate assembly 100 of Figs. 1-4 populated with multiple vertically mounted secondary substrates 50. Figs. 9-12 show a substrate assembly 200 that includes a modification to the substrate assembly 100 shown in Figs. 1-8 to accept secondary substrates 50 that are mounted horizontally. Each of the substrate assemblies 100, 200 disclosed in Figs. 1-12 can be included in, or can define, an electronic module.

As shown in Figs. 1-4, the substrate assembly 100 includes a main substrate 40, a secondary substrate 50, retainers 20, and a housing or enclosure 30. The housing or enclosure 30 includes a first housing portion 31 defining a horizontal wall 32 and a second housing portion 35 defining a vertical wall 36. The first housing portion 31 and the second housing portion 35 can be connected together to define a unitary housing or enclosure 30. The main substrate 40 is mounted to the wall 32 of a first housing portion 31, which can be a horizontal housing portion. Although Figs. 1-4 show the main substrate 40 is secured to the first housing portion 31 by mounting screws 33, the main substrate 40 can instead be mounted to the first housing portion 31 by a snap fit, glue, epoxy, and the like. The first housing portion 31 can also include additional mounting holes 34 that can be used to secure the first housing portion 31 to a further substrate, a further housing or enclosure 30, or the like.

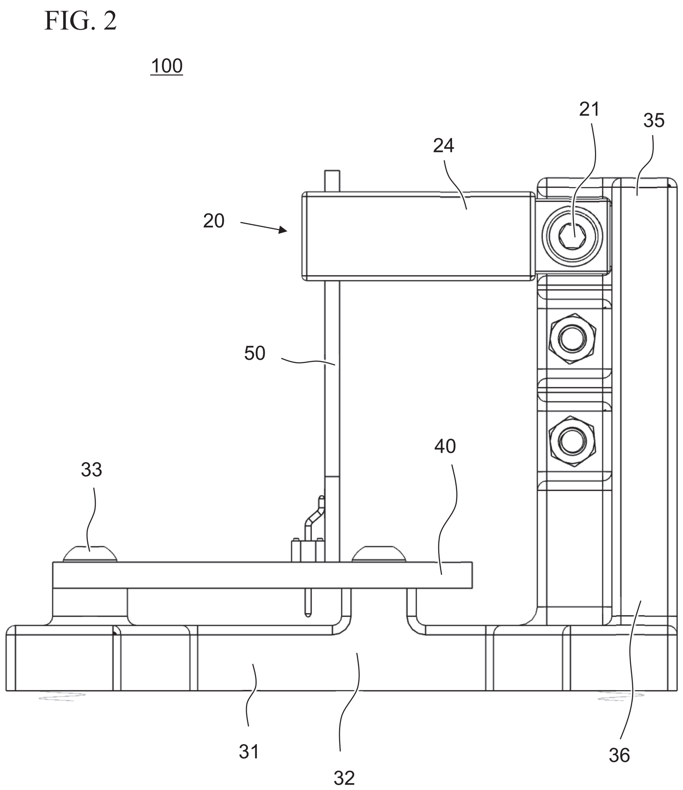

The second housing portion 35 can be a vertical housing portion. The second housing portion 35 can include a wall 36 that is perpendicular or substantially perpendicular within manufacturing and/or measurement tolerances to the wall 32 of the first housing portion 31. The second housing portion 35 can be integrally formed with, or directly connected to, the first housing portion 31. As shown in Figs. 1 and 2, the second housing portion 35 includes mounting points 37. The mounting points 37 can be defined by holes, such as holes with internal threads to receive a corresponding screw or holes that can receive a corresponding snap-fit structure. The mounting points 37 can be located on a beam or the like that extends from the wall 36 of the second housing portion 35. However, the specific structure and arrangement of the mounting points 37 is not limited. The mounting points 37 can be provided in pairs, so as to be located at opposing ends of the secondary substrate 50. The second housing portion 35 can include a plurality of mounting points 37, as discussed below with respect to Figs. 5-8.

As shown in Figs. 1 and 2, the mounting points 37 can secure retainers 20 to the second housing portion 35, and the retainers 20 can be fixed to the second housing portion 35 by fasteners 21. In particular, a mounting point 37 can be a threaded mounting point 37, the retainer 20 can include a though hole 23, and the retainer 20 can be fixed to the second housing portion 35 by the fastener 21 passing through the though hole 23 and mating with the threaded mounting point 37. The fasteners 21 can be, for example, retainer screws or bolts.

As shown in Figs. 1-4, the secondary substrate 50 can be mounted vertically. That is, a major planar surface of the secondary substrate 50 can be perpendicular or substantially perpendicular within manufacturing and/or measurement tolerances to a major planar surface of the main substrate 40. Stated differently, the main substrate 40 and the secondary substrate 50 can be oriented perpendicular or substantially perpendicular within manufacturing and/or measurement tolerances with respect to one another.

The secondary substrate 50 can be electrically connected to the main substrate 40. For example, as shown in Fig. 1, the main substrate 40 and the secondary substrate 50 can be connected by an electrical connector that provides both physical and electrical connections. Alternatively, the main substrate 40 and the secondary substrate 50 can be connected by a connector that provides only a physical connection, or the main substrate 40 and the secondary substrate 50 can be connected by an electrical connector that provides only an electrical connection, e.g., a cable. In addition, the secondary substrate 50 can also be directly physically connected to the main substrate 40.

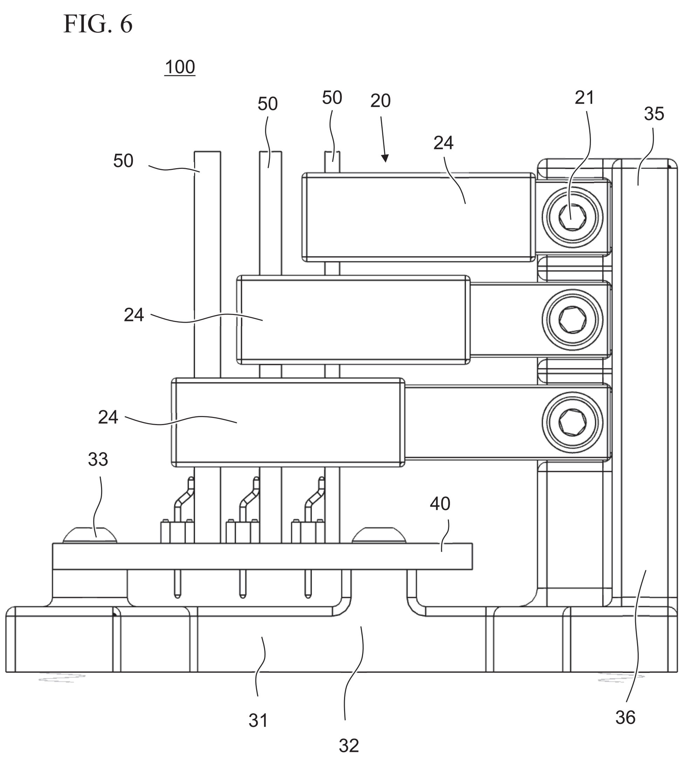

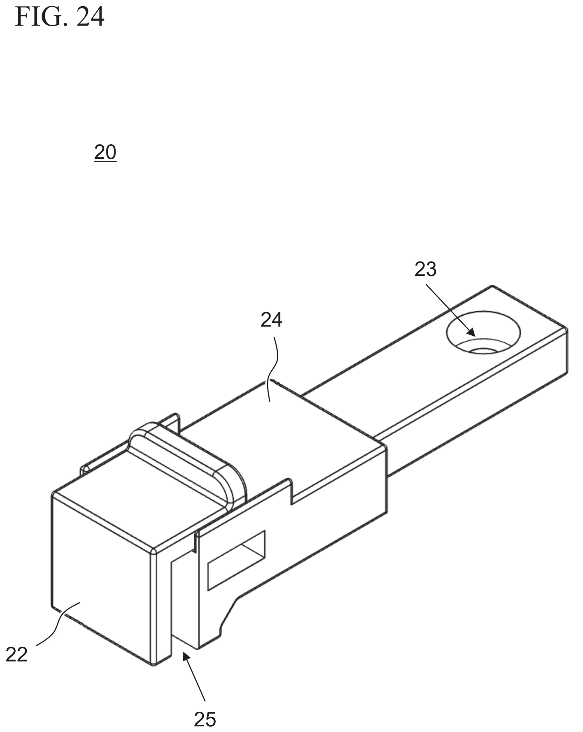

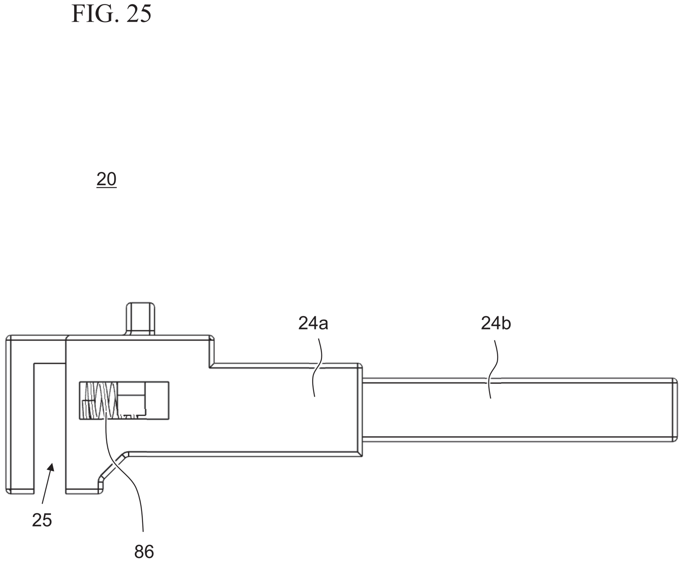

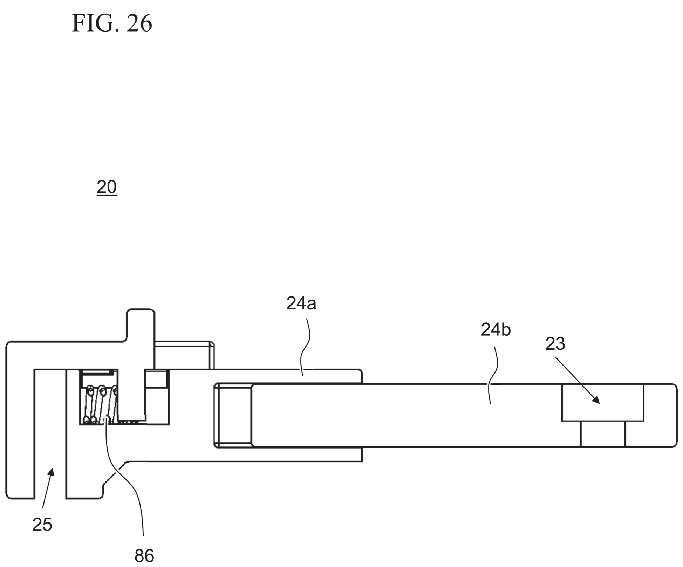

As shown in Figs. 1-4, the retainer 20 includes a clamp 22 and an adjustable arm 24. As discussed below, the clamp 22 can define a slot 25 that engages with an edge portion of the secondary substrate 50, and a spring 26, for example, a leaf spring, wire spring, or the like, can be provided in the clamp 22 to secure the secondary substrate 50. Alternatively or additionally, the retainer 20 can include an internal spring or an embedded spring 86, as shown in Figs. 24-26. The slot 25 can be arranged vertically, such that the slot 25 extends in a direction that is perpendicular or substantially perpendicular within manufacturing and/or measurement tolerances to a major planar surface of the main substrate 40. Furthermore, the clamp 22 can be configured to receive secondary substrates 50 that have various thicknesses, as shown, for example, in Fig. 6.

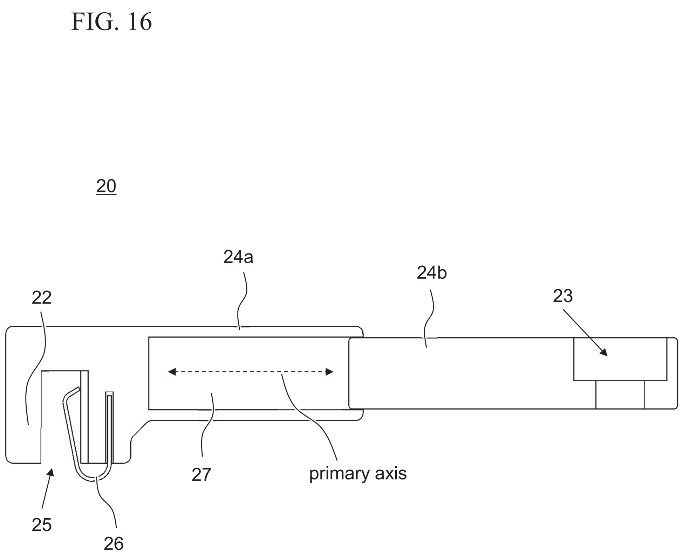

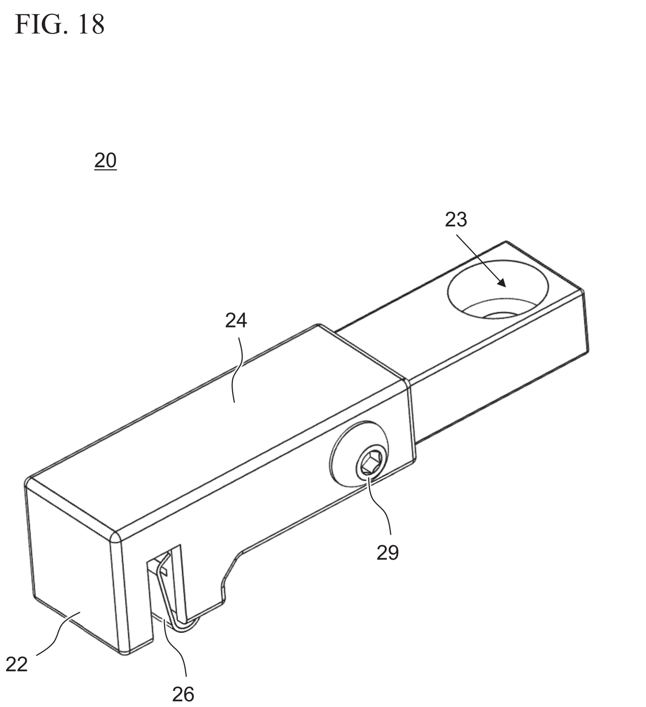

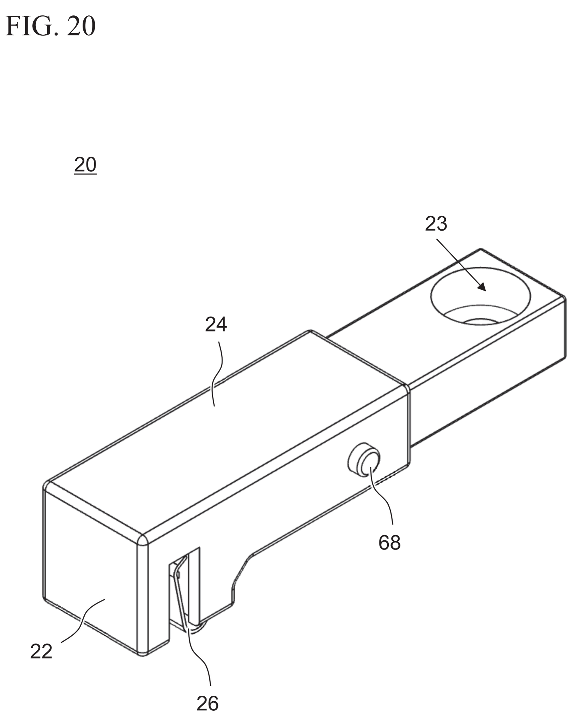

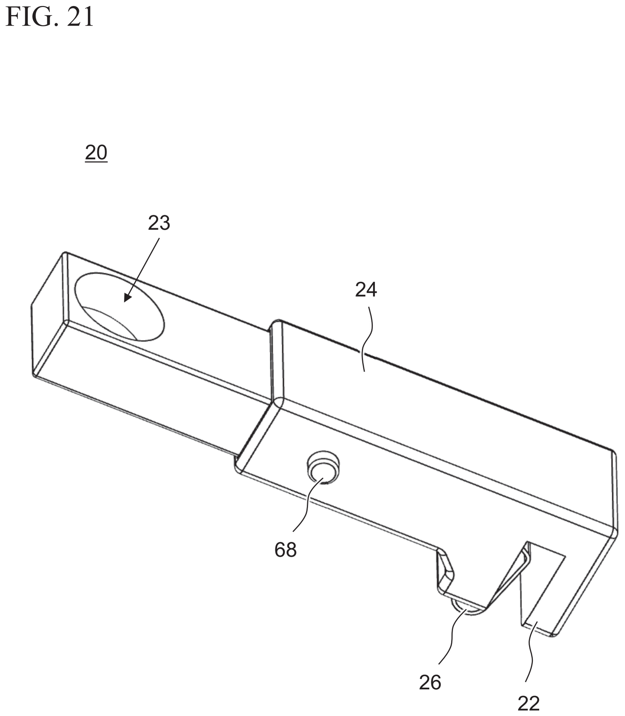

The adjustable arm 24 of the retainer 20 can vary in length (as discussed below and as shown, for example, in Fig. 16) in a direction that is parallel or substantially parallel within manufacturing and/or measurement tolerances to the major planar surface of the main substrate 40. Accordingly, a position of the secondary substrate 50 can be adjusted. For example, a location of the secondary substrate 50 can be adjusted to mate with a predetermined position of the main substrate 40, or the secondary substrate 50 can be positioned at a predetermined distance from the wall 36 of the second housing portion 35. A length of the adjustable arm 24 can be fixed after a predetermined length is set, for example, by tightening a set screw 29 (as shown in Fig. 18) or releasing a button release 68 provided with the adjustable arm 24 (as shown in Figs. 20 and 21).

Accordingly, the adjustable arm 24 provides flexibility for selectively positioning and locating the secondary substrate 50 to electrically connect, physically connect, or electrically and physically connect the secondary substrate 50 to the main substrate 40, without being constrained by a specific configuration relative to the housing or enclosure 30 (e.g., the specific location of the wall 36 of the second housing portion 35). Thus, an attachment point between the main substrate 40 and the secondary substrate 50 can be flexibly and accurately provided by the adjustable arm 24. Furthermore, the retainer 20 does not occupy any space on the main substrate 40, thereby enabling the main substrate 40 to be a high-density substrate that is still able to be connected to the secondary substrate 50.

Figs. 5-8 show the substrate assembly 100 of Figs. 1-4 populated with multiple vertically mounted secondary substrates 50.

As shown in Figs. 5-8, the substrate assembly 100 can be provided with a plurality of secondary substrates 50 that are each vertically mounted by corresponding retainers 20. Accordingly, the adjustable arms of the retainers 20 associated with different secondary substrates 50 can be separately adjusted to different lengths in order to position and locate each of the secondary substrates 50. Figs. 5-8 show three secondary substrates 50, but any number of secondary substrates 50 can be provided.

As shown in Fig. 6, the clamps 22 of the retainers 20 are able to secure multiple secondary substrates 50 at different locations, and the secondary substrates 50 can have different thicknesses. As examples, the arrangement shown in Fig. 6 shows that secondary substrates 50 having thicknesses of 0.062", 0.092" and 0.110" are able to be secured. However, the thicknesses of the secondary substrates 50 are not limited to these specific values, and thicker or thinner substrates can be secured by the retainers 20.

The plurality of secondary substrates 50 can be provided within a relatively limited space, and the retainers 20 do not occupy any space on the main substrate 40. Accordingly, the main substrate 40 can be a high-density substrate that is able to electrically connect, physically connect, or electrically and physically connect to the plurality of secondary substrates 50. For example, electrical connectors can provide both physical and electrical connections between the main substrate 40 and the secondary substrates 50. Alternatively, the main substrate 40 and the secondary substrates 50 can be connected by connectors that provide only physical connections, or the main substrate 40 and the secondary substrates 50 can be connected by electrical connectors that provide only electrical connection, e.g., cables. Furthermore, the attachment points between the main substrate 40 and the plurality of secondary substrates 50 can be flexibly and accurately provided by using adjustable arms, thereby enabling each of the plurality of secondary substrates 50 to be selectively positioned with respect to the main substrate 40 while requiring a limited footprint on the main substrate 40 for the attachment points.

Figs. 9-12 show a substrate assembly 200 including horizontally mounted secondary substrates 50.

Figs. 9-12 show a modification to the substrate assembly 100 shown in Figs. 1-8 to accept secondary substrates 50 that are mounted horizontally. That is, a major planar surface of the secondary substrates 50 shown in Figs. 9-12 can be parallel or substantially parallel within manufacturing and/or measurement tolerances to a major planar surface of the main substrate 40. Stated differently, the main substrate 40 and the secondary substrates 50 can be oriented parallel or substantially parallel within manufacturing and/or measurement tolerances with respect to one another. Figs. 9-12 show two secondary substrates 50, but any number of secondary substrates 50 can be provided.

As shown in Figs. 9-12, the retainers 20 can be modified such that the clamp 22 defines a slot 25 extending horizontally, that is, in a direction that is parallel or substantially parallel within manufacturing and/or measurement tolerances to the major planar surface of the main substrate 40. Accordingly, the slots 25 of the retainers 20 can engage with edge portions of secondary substrates 50 that are mounted horizontally. The clamps 22 can each be provided with a spring 26, for example, a leaf spring, a wire spring, or the like, to secure the horizontally mounted secondary substrates 50. Alternatively or additionally, the retainer 20 can include an internal spring or an embedded spring 86, as shown in Figs. 24-26.

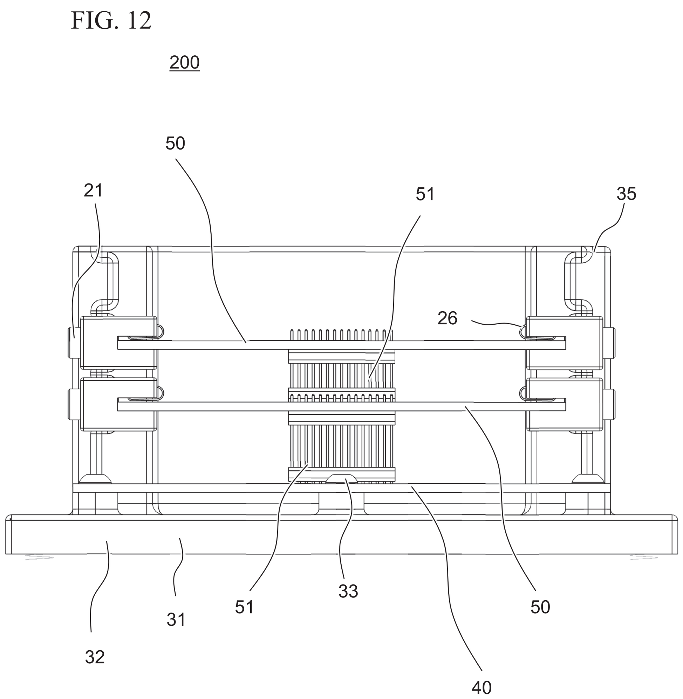

As shown in Figs. 9, 10, and 12, the substrate assembly 200 including horizontally mounted secondary substrates 50 can be provided with intermediate connectors 51. The intermediate connectors 51 can be physically connected to the main substrate 40 and/or the secondary substrates 50. For example, as shown in Figs. 9, 10, and 12, a first intermediate connector 51 can be physically connected to the main substrate 40 and a first secondary substrate 50, such that electrical power and/or electrical signals can be transmitted between the main substrate 40 and the first secondary substrate 50. As another example, as shown in Figs. 12, a second intermediate connector 51 can be physically connected to the first secondary substrate 50 and a second secondary substrate 50, such that electrical power and/or electrical signals can be transmitted between the first secondary substrate 50 and the second secondary substrate 50. Each of the intermediate connectors 51 can be provided by any suitable board-to-board connector. Alternatively, cabled connections can be provided in place of one or more of the intermediate connectors 51.

When manufacturing or assembling the substrate assembly 200 including multiple horizontally mounted secondary substrates 50 shown in shown in Figs. 9-12, the main substrate 40 and the secondary substrate(s) 50 can be connected by the intermediate connectors 51 before the retainers 20 are attached to secure the secondary substrate(s) 50. According to another implementation, the secondary substrates 50, intermediate connectors 51, and retainers 20 can be attached in an alternating manner, for example, mounting the main substrate 40, then mounting a first intermediate connector 51 to the main substrate 40, then mounting a first secondary substrate 50 to the first intermediate connector 51 and securing the first secondary substrate 50 with retainers 20, then mounting a second intermediate connector 51 to the first secondary substrate 50, and then mounting a second secondary substrate 50 to the second intermediate connector 51 and securing the second secondary substrate 50 with retainers 20.

Similar to the substrate assembly 100 including multiple vertically mounted secondary substrates 50 shown in Figs. 5-8, the substrate assembly 200 including multiple horizontally mounted secondary substrates 50 shown in shown in Figs. 9-12 can secure multiple secondary substrates 50 that have different thicknesses.

The substrate assemblies shown in Figs. 1-12 can include the same housing or enclosure 30. That is, a housing or enclosure 30 including vertically mounted substrate(s) can be adapted to receive horizontally mounted substrate(s) by simply changing the retainers 20 and, optionally, providing intermediate connectors 51. Similarly, a housing or enclosure 30 including horizontally mounted substrate(s) can be adapted to receive vertically mounted substrate(s) by changing the retainers 20.

Furthermore, although each of the substrate assemblies 100, 200 shown in Figs. 1-12 is shown with each of the secondary substrates 50 being secured by two retainers 20, one or more of the secondary substrate(s) 50 can be secured by three or more retainers 20. Providing additional retainers 20 to secure the secondary substrates 50 can provide additional support to secure the secondary substrates 50, for example, to reduce or prevent movement of the secondary substrates 50 during high vibration.

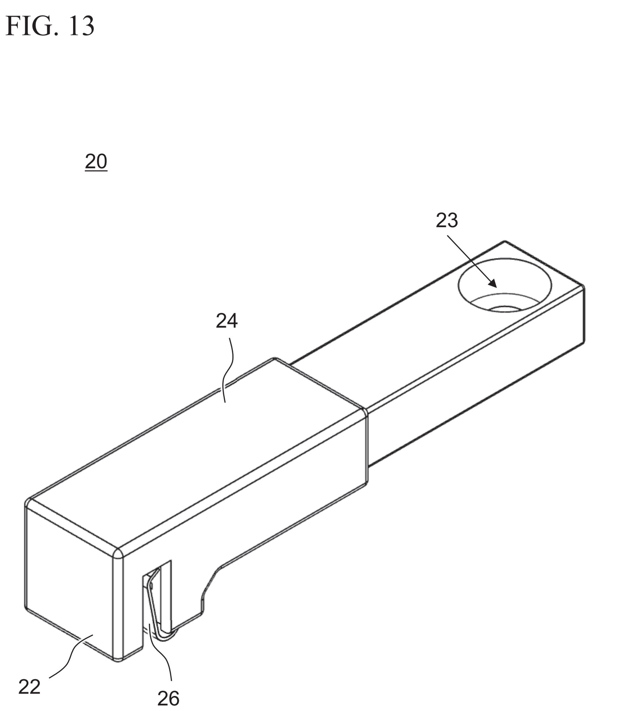

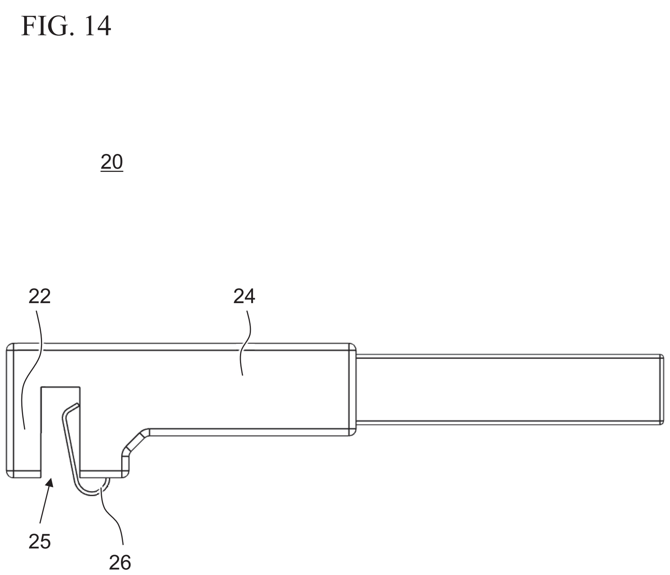

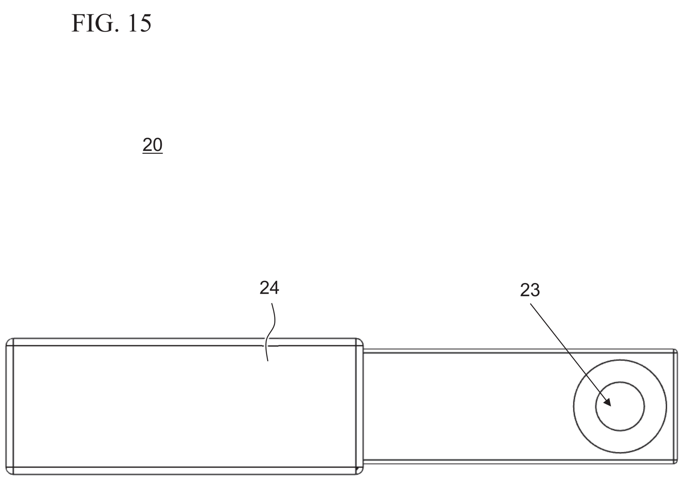

Figs. 13-16 show a retainer 20 including a leaf spring as the spring 26. The retainer 20 shown in Figs. 13-16 can be implemented and/or modified to be used with any of the substrate assemblies shown in Figs. 1-12.

As shown in Figs. 13-16, the retainer 20 includes a clamp 22, an adjustable arm 24, and a though hole 23.

The clamp 22 is configured to receive a secondary substrate 50, in particular, an edge portion of a secondary substrate 50. The clamp 22 can be configured to receive substrates of various thicknesses. As shown in Figs. 13, 14, and 16, the clamp 22 can include the leaf spring as the spring 26. The leaf spring can enable substrates of multiple thicknesses to be secured by the clamp 22. That is, the leaf spring can provide a tight, frictional fit for different substrates.

The adjustable arm 24 can include a first arm portion 24a and a second arm portion 24b. As shown in Fig. 16, the first arm portion 24a can include a void space 27 that receives the second arm portion 24b to allow an overall length of the retainer 20 to be adjusted. The second arm portion 24b can move within the void space 27 of the first arm portion 24a along a primary axis of the adjustable arm 24. The second arm portion 24b can freely move within the void space 27 of the first arm portion 24a, or a frictional fit can be provided between the first arm portion 24a and the second arm portion 24b.

The retainer 20 can include a though hole 23, which can be used to fix the retainer 20 to a housing or enclosure 30 by a fastener 21 passing through the though hole 23 and mating with a threaded mounting point 37 the housing or enclosure 30.

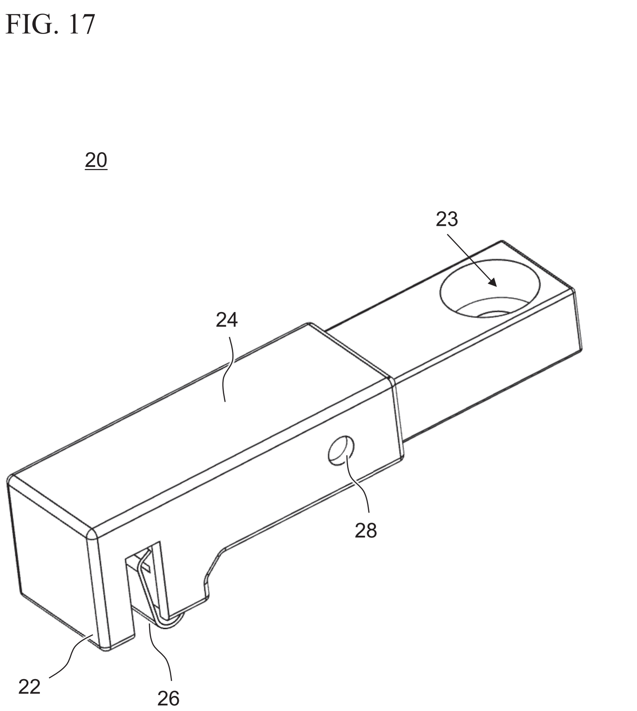

Figs. 17-19 show a retainer 20 configured to mate with a set screw 29. The retainer 20 shown in Figs. 17-19 can be implemented and/or modified to be used with any of the substrate assemblies shown in Figs. 1-12.

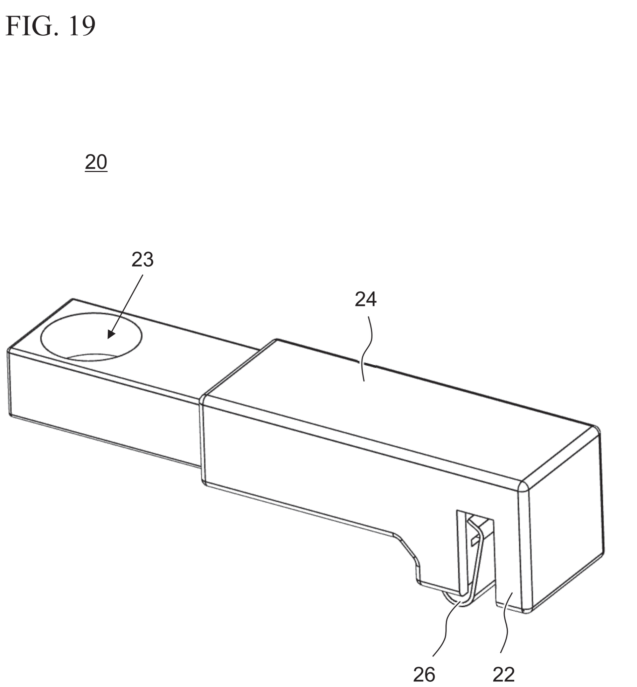

As shown in Fig. 17, the adjustable arm 24 of the retainer 20 can include a hole 28, and the hole 28 can be threaded. As shown in Fig. 18, a set screw 29 can be mated with the hole 28 in the adjustable arm 24 of the retainer 20. As shown in Fig. 19, the hole 28 and the set screw 29 can be provided on only one side of the retainer 20. However, the retainer 20 can also be provided with a hole 28 and a set screw 29 on any surface thereof.

A length of the adjustable arm 24 can be fixed after a predetermined length is set, for example, by tightening the set screw 29. However, if the set screw 29 is then loosened, the length of the adjustable arm 24 can be made to vary, such that a new predetermined length can be set.

Figs. 20 and 21 show a retainer 20 including a button releases 68. The retainer 20 shown in Figs. 20 and 21 can be implemented and/or modified to be used with any of the substrate assemblies shown in Figs. 1-12.

As shown in Figs. 20 and 21, a button release 68 can be provided on opposing sides of the adjustable arm 24 of the retainer 20. However, the retainer 20 can alternatively be provided with only a single button release 68.

While the button releases 68 are pressed down, the length of the adjustable arm 24 can be varied. When the button releases 68 are not pressed own, the length of the adjustable arm 24 becomes fixed. However, the button releases 68 can again be pressed down so that a new predetermined length can be set.

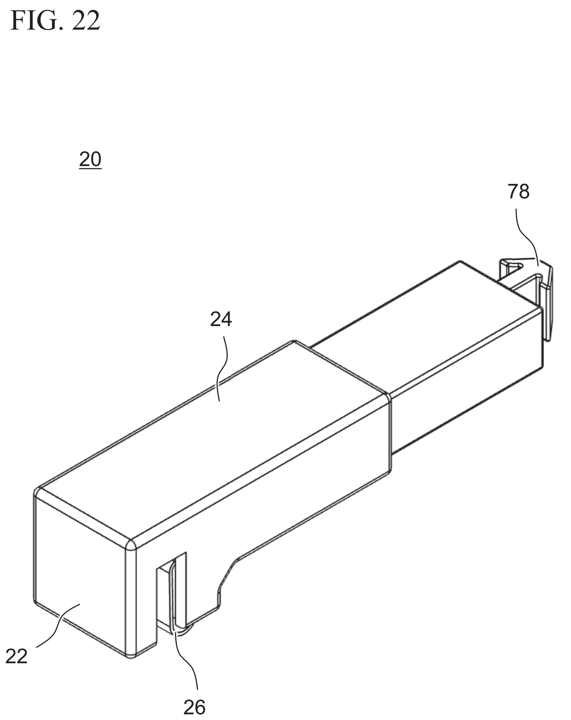

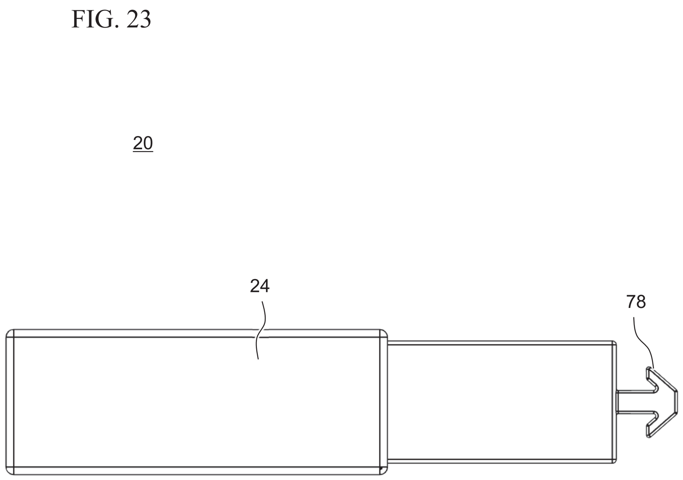

Figs. 22 and 23 show a retainer 20 including a snap-fit portion 78. The retainer 20 shown in Figs. 22 and 23 can be implemented and/or modified to be used with any of the substrate assemblies shown in Figs. 1-12.

Instead of a though hole 23 used to mount a retainer 20 using a fastener 21 as described above with respect to Figs. 1-4 and 13-16, the retainer 20 shown in Figs. 22 and 23 includes a snap-fit portion 78. The snap-fit portion 78, and a corresponding snap fit mounting point 37 of a housing or enclosure 30 can receive and engage with the snap-fit portion 78 to attach and secure the retainer 20 to the housing or enclosure 30.

Figs. 24-26 show a retainer 20 including an internal or embedded spring 86. The retainer 20 shown in Figs. 24-26 can be implemented and/or modified to be used with any of the substrate assemblies shown in Figs. 1-12.

Instead of a leaf spring, a clamp 22 of the retainer 20 shown in Figs. 24-26 includes a clamp 22 that is adjustable. The clamp 22 includes an internal or embedded spring 86 that is able to vary a width of a slot 25 defined by the clamp 22. The clamp 22 can have moveable portion that is pushed on by the internal or embedded spring 86 to vary the width of the slot 25. The clamp 22 can also have a tab that can be manually manipulated to move the moveable portion against the internal or embedded spring 86. Accordingly, the clamp 22 shown in Figs. 24-26 is able to secure and engage with substrates, while also receiving substrates that have various thicknesses.

Electronic component(s) can be provided on any of the main substrates 40 and the secondary substrates 50. The electronic component(s) can be active components, such as transistors, integrated circuits (ICs), etc., or can be passive components, such as resistors, capacitors, inductors, etc.

Each of the substrate assemblies described herein can be, for example, a power converter, isolator, or transformer, and electronic components of each of the substrate assemblies can be the components of the power converter, isolator, or transformer. Each of the substrate assemblies can be any suitable power converter, including, for example, a DC-DC converter or an AC-DC converter.

Each of the main substrates 40 and the secondary substrates 50 can be any suitable substrate, including, for example, a printed circuit board (PCB). Each of the main substrates 40 and the secondary substrates 50 can include a single layer or multiple layers and can include traces or conductive patterns on an exterior surface (i.e., the top and the bottom surfaces) of the substrate and/or in the substrate (i.e., on an internal layer of the substrate).

The housing or enclosure 30 can be made of any suitable material and can be made in any suitable manner. For example, the housing or enclosure 30 can be made of an insulating material, including, for example, plastic or liquid crystal polymer (LCP) resin or can be made of metal, including, for example, steel or aluminum alloys. Electrical connections and terminals of the main substrate 40 and the secondary substrates 50 can be made of any suitable conductive material, including, for example, copper or copper alloy.

The retainers 20 can be made of any suitable material and can be made in any suitable manner. For example, the retainers 20 can be made of any suitable plastic material based upon thermal requirements and insulation requirements for the substrate assembly 100, 200. As another example, the retainers 20 can be made with glass filled nylon for high temperature applications.

It should be understood that the foregoing description is only illustrative of the present invention. Various alternatives and modifications can be devised by those skilled in the art without departing from the present invention. Accordingly, the present invention is intended to embrace all such alternatives, modifications, and variances that fall within the scope of the appended claims.

## Claims

1. A substrate assembly comprising:
a first substrate;
a second substrate;
a retainer attached to the second substrate; and
a housing connected to the first substrate, wherein
the retainer is mounted to the housing,
the first substrate and the second substrate are electrically connected, and
the retainer includes:
an adjustable arm that is configured to vary in length, and
a clamp that engages the second substrate.

2. The substrate assembly of claim 1, wherein a major planar surface of the second substrate is perpendicular or substantially perpendicular to a major planar surface of the first substrate.

3. The substrate assembly of one of claims 1-3, wherein the first substrate and the second substrate are directly physically connected.

4. The substrate assembly of claim 1, wherein a major planar surface of the second substrate is parallel or substantially parallel to a major planar surface of the first substrate.

5. The substrate assembly of one of claims 1 or 5, further comprising an intermediate connector connecting the first substrate and the second substrate.

6. The substrate assembly of one of claims 1-5, wherein
the clamp defines a slot that engages with an edge portion of the second substrate, and
the slot of the clamp includes a leaf spring or an embedded spring.

7. The substrate assembly of one of claims 1-6, wherein the adjustable arm is configured to vary in length in a direction that is parallel or substantially parallel to a major planar surface of the first substrate.

8. The substrate assembly of one of claims 1-7, wherein:
the adjustable arm includes a set screw,
when the set screw is loosened, the adjustable arm is configured to vary in length, and
when the set screw is tightened, the adjustable arm is configured to be fixed in length.

9. The substrate assembly of one of claims 1-7, wherein:
the adjustable arm includes a button release,
when the button release is pressed down, the adjustable arm is configured to vary in length, and
when the button release is not pressed down, the adjustable arm is configured to be fixed in length.

10. The substrate assembly of one of claims 1-9, further comprising:
a fastener, wherein
the retainer includes a through hole,
the housing includes a threaded mounting point, and
the retainer is attached to the housing by the fastener passing through the through hole and mating with the threaded mounting point.

11. The substrate assembly of one of claims 1-9, wherein:
the adjustable arm includes a snap fit mounting portion,
the housing includes a snap fit mounting point, and
the retainer is attached to the housing by the snap fit mounting portion engaging with the snap fit mounting point.

12. The substrate assembly of one of claims 1-11, wherein:
the housing includes a first housing portion and a second housing portion,
the first housing portion is connected to the first substrate,
the retainer is mounted to the second housing portion, and
the first housing portion defines a wall that is perpendicular or substantially perpendicular to a wall defined by the second housing portion.

13. The substrate assembly of claims 1-12, further comprising:
a third substrate; and
an additional retainer attached to the third substrate.

14. The substrate assembly of claim 13, wherein
a major planar surface of the second substrate is parallel or substantially parallel to a major planar surface of the third substrate, or
a major planar surface of the third substrate is perpendicular or substantially perpendicular to a major planar surface of the first substrate.

15. The substrate assembly of claim 13 or 14, wherein a thickness of the second substrate is different from a thickness of the third substrate.
